Europäisches Patentamt

European Patent Office

Office européen des brevets

(11) Veröffentlichungsnummer: **0 351 708**
**A2**

## (12) EUROPÄISCHE PATENTANMELDUNG

(21) Anmeldenummer: **89112768.0**

(22) Anmeldetag: **12.07.89**

(51) Int. Cl.⁴: **H03F 3/72 , H03F 1/02**

(30) Priorität: **21.07.88 DE 3824830**

(43) Veröffentlichungstag der Anmeldung:
**24.01.90 Patentblatt 90/04**

(84) Benannte Vertragsstaaten:
**BE DE FR GB IT NL SE**

(71) Anmelder: **Siemens Aktiengesellschaft**
**Wittelsbacherplatz 2**
**D-8000 München 2(DE)**

(72) Erfinder: **Hosticka, Bedrich J., Prof**
**Zieglerstrasse 27**
**D-4100 Duisburg(DE)**
Erfinder: **Klinke, Roland, Dipl.-Ing.**
**Tölckestrasse 16**
**D-4600 Dortmund(DE)**
Erfinder: **Pfleiderer, Hans-Jörg, Prof.-Dr.**
**Franz-Krinninger-Weg 23**
**D-8011 Zorneding(DE)**

(54) **Differenzverstärker mit extern steuerbarer Leistungsaufnahme.**

(57) Differenzverstärker mit einer externen Schaltungsstufe (T8 bis T10) zur signalabängigen Einstellung der Stromaufnahme. Die Schaltungsstufe besteht aus zwei zueinander parallel geschalteten Feldeffekttransistoren (T8, T9), die in Serie zu einem ausgangsseitigen Widerstand (T10) angeordnet sind, über den die Stromquelle (T3) des Differenzverstärkers eingestellt wird. Die Feldeffekttransistoren (T8, T9) werden vom Verstärkereingang her über eine pegelumsetzende Schaltung (PU) angesteuert, die mit einem Regelkreis (7) ausgestattet ist. Dieser bestimmt die Arbeitspunkte der Feldeffekttransistoren (T8, T9) ohne und mit anliegendem Eingangssignal und kontrolliert somit die signalabhängige Erhöhung des Verstärkerstroms.

EP 0 351 708 A2

FIG 1

## Differenzverstärker mit extern steuerbarer Leistungsaufnahme

Die Erfindung bezieht sich auf einen Differenzverstärker nach den gleichlautenden Oberbegriffen der Patentansprüche 1 und 2.

Ein Differenzverstärker dieser Art ist in dem Buch "Design of MOS VLSI Circuits for Telecommunications" von Y. Tsividis und P. Antognetti, erschienen im Verlag Prentice Hall, N. J. (1985) auf den Seiten 129-136, vgl. insbesondere Fig. 5.4, beschrieben. Dort werden zwei der Stromquelle parallel geschaltete, zusätzliche, als steuerbare Stromquellen dienende Feldeffekttransistoren über Stromspiegelschaltungen von den in den parallelen Schaltungszweigen fließenden Strömen derart beeinflußt, daß beim Überschreiten eines festen Spannungswertes durch das einer Gatevorspannung überlagerte Eingangssignal der eine zusätzliche Feldeffekttransistor einen den Ruhestrom der Stromquelle verstärkenden Zusatzstrom liefert, beim Unterschreiten des festen Spannungswertes durch das überlagerte Eingangssignal der andere zusätzliche Feldeffekttransistor. Die Stromspiegelschaltungen sind so ausgebildet, daß der niedrige Ruhestrom durch das signalabhängige Auftreten der Zusatzströme jeweils stark vergrößert wird. Damit erreicht man gute Treibereigenschaften bei gleichzeitiger Reduzierung der Verlustleistung des Differenzverstärkers.

Ein Nachteil dieses bekannten Verstärkers besteht jedoch darin, daß insbesondere bei Zuführung eines Eingangssignals mit steil ansteigenden und abfallenden Flanken, z.B. einer Rechteckspannung, in den aus den parallelen Schaltungszweigen, den Stromspiegelschaltungen und den steuerbaren Stromquellen gebildeten Regelkreisen Instabilitäten auftreten, die sehr oft zu einer Verzerrung des Ausgangssignals führen.

In der älteren deutschen Patentanmeldung P 37 01 791.8 ist ein Differenzverstärker der eingangs genannten Art beschrieben, bei St 1 Sti/18.07.1988 dem zwei der Stromquelle parallel geschaltete, als steuerbare Stromquellen dienende Feldeffekttransistoren vom Schaltungseingang her über eine pegelumsetzende Schaltung so angesteuert werden, daß der niedrige Ruhestrom durch ein vom Eingangssignal abhängiges Auftreten der Zusatzströme jeweils stark vergrößert wird. Gegenüber dem erstgenannten bekannten Differenzverstärker besteht hier der wesentliche Vorteil, daß keine Regelung der zusätzlichen Stromquellen von der Verstärkerausgangsseite, sondern eine Steuerung derselben von der Verstärkereingangsseite her erfolgt, und daß somit auch bei zu übertragenden Rechteckspannungen keine wesentlichen Verzerrungen des Ausgangssignals auftreten.

Der Erfindung liegt die Aufgabe zugrunde, einen Differenzverstärker der eingangs genannten Art anzugeben, der durch eine signalabhängige Anhebung seines niedrigen Ruhestroms gute Treibereigenschaften bei niedriger Verlustleistung aufweist und bei dem eine im Vergleich zu den bekannten Differenzverstärkern einfache Erzeugung der zusätzlichen signalabhängigen, sich dem Ruhestrom überlagernden Stromkomponenten erfolgt. Das wird erfindungsgemäß durch eine Ausbildung nach den kennzeichnenden Teilen des Patentanspruchs 1 oder des Patentanspruchs 2 erreicht.

Der mit der Erfindung erzielbare Vorteil besteht insbesondere darin, daß die den Ruhestrom des Differenzverstärkers erzeugende Stromquelle gleichzeitig auch für die Erzeugung der zusätzlichen Stromkomponenten verwendet wird, wobei lediglich eine modifizierte Ansteuerung dieser Stromquelle vorzusehen ist. Diese Modifizierung erfolgt außerhalb der eigentlichen Schaltung des Differenzverstärkers und ist somit eine externe Schaltungsmaßnahme.

Die Patentansprüche 3 und 4 sind auf bevorzugte Ausgestaltungen und Weiterbildungen der Erfindung gerichtet.

Die Erfindung wird nachfolgend anhand eines in der Zeichnung dargestellten, bevorzugten Ausführungsbeispiels näher erläutert. Dabei zeigt:

Fig. 1 das Schaltungsprinzip eines Differenzverstärkers nach der Erfindung,

Fig. 2 ein Spannungs-Zeit-Diagramm zur Erläuterung der Wirkungsweise des Differenzverstärkers nach Fig. 1, und

Fig. 3 eine Schaltung zur Erzeugung einer in Fig. 1 benötigten Referenzspannung.

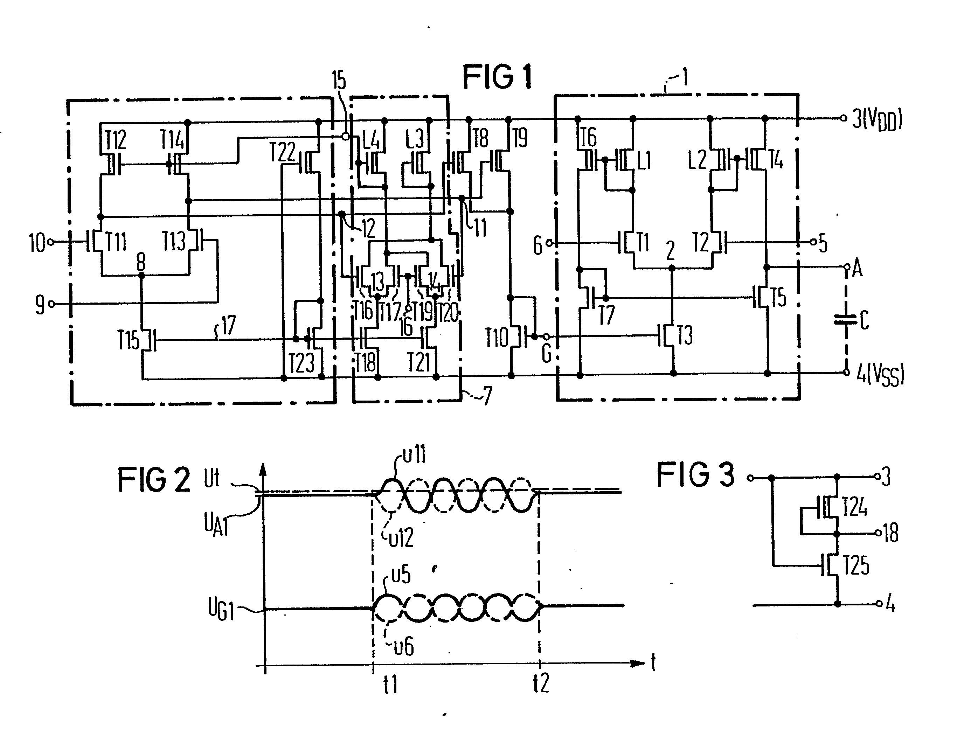

In Fig. 1 ist eine beispielhafte Ausführungsform eines Differenzverstärkers innerhalb des strichpunktierten Blocks 1 dargestellt. Ein Schaltungsknoten 2 ist dabei über zwei parallele Schaltungszweige, von denen der eine die Serienschaltung eines Lastelements L1 und eines n-Kanal-Feldeffekttransistors T1 und der andere die Serienschaltung eines Lastelements L2 und eines n-Kanal-Feldeffekttransistors T2 enthält, mit einem Anschluß 3 verbunden, der mit einer Versorgungsspannung $V_{DD}$ beschaltet ist. Andererseits ist der Schaltungsknoten 2 über einen weiteren Schaltungszweig, der einen als Stromquelle geschalteten n-Kanal-Feldeffekttransistor T3 enthält, mit einem Anschluß 4 verbunden, der auf Bezugspotential $V_{SS}$ liegt. Die Lastelemente L1 und L2 bestehen jeweils aus einem p-Kanal-Feldeffekttransistor, dessen Drainanschluß mit seinem Gateanschluß verbunden ist. Zwischen den Anschlüssen 3 und 4 liegt die Serienschaltung eines p-Kanal-Feldeffekttransistors T4 und eines n-Kanal-Feldeffekttransistors T5, wobei das Gate von T4 mit dem Gate des das Lastelement L2 bildenden Feldeffekttransistors verbunden ist. Ein weiterer, die Anschlüsse 3 und 4 miteinander verbindender Schaltungszweig enthält die Serienschaltung eines p-Kanal-Feldeffekttransistors T6 und eines n-Kanal-Feldeffekttransistors T7, wobei das Gate von T6 mit dem Gate des das Lastelement L1 bildenden Feldeffekttransistors verbunden ist. Das Gate von T7 ist sowohl mit dem Drainanschluß von T7 als auch mit dem Gate von T5 beschaltet. Der Verbindungspunkt von T4 und T5 ist an den Ausgang A des Differenzverstärkers geführt, während die Gateanschlüsse 5 und 6 der Transistoren T2 und T1 jeweils den positiven und den negativen Verstärkereingang darstellen.

Mit dem Gateanschluß G von T3 ist eine Schaltungsstufe verbunden, die zunächst die Funktion hat, die Ruheströme einzustellen, die ohne das Auftreten eines zu verstärkenden Eingangssignals an den Eingängen 5 und 6 in den parallelen Schaltungszweigen L1, T1 und L2, T2 fließen. Sie besteht aus zwei einander parallel geschalteten p-Kanal-Feldeffekttransistoren T8 und T9, die jeweils in Serie zu einem den ausgangsseitigen Widerstand dieser Stufe darstellenden n-Kanal-Feldeffekttransistor T10 liegen. Die Serienschaltungen von T8 und T10 sowie von T9 und T10 sind dabei zwischen die Anschlüsse 3 und 4 geschaltet. Das Gate von T10 ist sowohl mit dem Drainanschluß von T10 als auch mit dem Gateanschluß G von T3 verbunden. Wird den Gates von T8 und T9, wie später noch näher erläutert werden soll, eine Referenzspannung $U_{ref}$ zugeführt, die nur wenig unterhalb der Einsatzspannung $U_t$ dieser Transistoren liegt, so fließen konstante, gleichgroße Ströme durch T8 und T9, die sich zu einem T10 durchfließenden Summenstrom zusammensetzen. Dieser läßt am Drainanschluß von T10 eine konstante Vorspannung abfallen, die über G auch dem Gate von T3 zugeführt wird, und diesen Transistor auf einen festen Arbeitspunkt einstellt, in dem er einen Ruhestrom $I_0$ liefert. $I_0$ entspricht der Summe der gleichgroßen Ruheströme $I_0/2$, die die parallelen Schaltungszweige L1, T1 und L2, T2 durchfließen. Die Gates von T1 und T2 sind dabei mit einer Vorspannung $U_{G1}$ beschaltet, die so bemessen ist, daß sich T1 und T2 im leitenden Zustand befinden. Stimmen die strukturellen Auslegungen der Transistoren L2 und T4 überein, so bilden diese einen Stromspiegel, der bewirkt, daß nicht nur L2, sondern auch der Transistor T4 von $I_0/2$ durchflossen wird. In analoger Weise sorgt der aus L1 und T6 bestehende Stromspiegel bei gleicher struktureller Auslegung dieser Transistoren dafür, daß nicht nur L1, sondern auch T6 und damit T7 von $I_0/2$ durchflossen werden. Der aus den gleichstrukturierten Transistoren T7 und T5 bestehende Stromspiegel sorgt schließlich dafür, daß T5 ebenso wie T7 von

$I_0/2$ durchflossen wird. Gleichgroße Ströme in den Source-Drain-Strecken von T4 und T5 bedeuten aber, daß über den Ausgang A kein Strom in einen nachgeschalteten Laststromkreis fließt, der durch eine Kapazität C angedeutet wird.

Dieser Ruhestrombetrieb entspricht einem relativ geringen Leistungsverbrauch. Erst beim Auftreten eines zu verstärkenden Eingangssignals an den Verstärkereingängen 5 und 6 soll nun die Aussteuerung des Transistors T3 so stark erhöht werden, daß der Differenzverstärker 1 in der Lage ist, dem bei A angeschlossenen, unter Umständen einen großen Widerstand aufweisenden Laststromkreis ein möglichst unverzerrtes und unverzögertes Ausgangssignal zuzuführen. Zu diesem Zweck ist eine pegelumsetzende Schaltung PU vorgesehen, die mit einem Gleichtakt-Regelkreis 7 ausgestattet ist. Die Eingänge von PU sind mit 9 und 10 bezeichnet, wobei 9 mit dem Eingang 5 des Differenzverstärkers 1 und 10 mit dem Eingang 6 desselben verbunden ist. Der obere Ausgang 11 von PU liegt am Gate von T9, der untere Ausgang 12 am Gate von T8.

Die Funktion der pegelumsetzenden Schaltung PU besteht einerseits darin, beim Auftreten eines zu verstärkenden Eingangssignals an den Anschlüssen 5 und 6 die die Transistoren T8 oder T9 durchfließenden Ströme so anzuheben, daß am Gateanschluß G eine höhere Spannung abfällt, welche dann über T3 auch in den parallelen Schaltungszweigen L1, T1 und L2, T2 einen starken Stromanstieg hervorruft. Andererseits sorgt PU auch dafür, daß vor und nach dem Auftreten eines zu verstärkenden Eingangssignals die durch $U_{ref}$ definierten Arbeitspunkte von T8 und T9, die die Ruheströme in L1, T1 und L2, T2 bestimmen, unverändert bestehen bleiben und daß beim Auftreten eines Eingangssignals die Aussteuerung von T8 und T9 invers erfolgt, und zwar so, daß der arithmetische Mittelwert der jeweils an den Gates von T8 und T9 anliegenden Spannungen zu jedem Zeitpunkt der Referenzspannung $U_{ref}$ entspricht.

Nachfolgend sei die inverse Ansteuerfunktion von PU beim Auftreten eines Eingangssignals u1 näher betrachtet: Nimmt man an, daß dem Verstärkereingang 5 zum Zeitpunkt t1 ein beispielsweise sinusförmiges Eingangssignal u1 zugeführt wird, daß sich der Vorspannung $U_{G1}$ überlagert, so ergibt sich an 5 ein resultierendes Signal u5, dessen Zeitabhängigkeit in Fig. 2 mit einer ausgezogenen Linie angedeutet ist. Am Eingang 6 liegt dann wegen der inversen Aussteuerung mit u1 ein Signal u6, das in Fig. 2 durch den gestrichelten Verlauf der Spannungskurve gekennzeichnet ist. Durch die Wirkungsweise der pegelumsetzenden Schaltung PU werden an den Ausgängen 11 und 12 Spannungen erhalten, die in Fig. 2 mit u11 und u12 bezeichnet sind. Im einzelnen entspricht u11 einem dem Gate von T9 zugeführten Vorspannungswert $U_{A1}$, dem das in PU verstärkte Eingangssignal u1 überlagert ist, während sich u12 aus dem Vorspannungswert $U_{A1}$ und einem diesem überlagerten, verstärkten und invertierten Eingangssignal u1 zusammensetzt. Liegt $U_{A1}$ geringfügig unter der Einsatzspannung $U_t$ der Transistoren T8 und T9, wie in Fig. 2 angedeutet ist, so steuert jede $U_t$ unterschreitende negative Sinushalbwelle von u11 den Transistor T9 weiter aus, so daß ein vergrößerter Strom von 3 über T9 nach 4 fließt. Hierdurch erhöht sich die am Anschluß G liegende Spannung, die dem Gate von T3 zugeführt wird, so daß auch der von T3 den Zweigen L1, T1 und L2, T2 zugeführte Strom stark erhöht wird. Analog hierzu steuert jede $U_t$ unterschreitende Sinushalbwelle von u12 den Transistor T8 weiter aus, so daß ein vergrößerter Strom von 3 über T8 nach 4 fließt. Dieser bewirkt, daß die am Anschluß G liegende Spannung erhöht wird, so daß der von T3 den Zweigen L1, T1 und L2, T2 zugeführte Strom auch in diesen Zeitabschnitten stark erhöht wird. Während des Auftretens des zu verstärkenden Eingangssignals u1, d.h. innerhalb des Zeitintervalls t1 bis t2, wird somit der über t3 kontrollierte Strom durch die parallelen Schaltungszweige L1, T1 und L2, T2 stark angehoben, so daß gute Treibereigenschaften des Differenzverstärkers erreicht werden. Die hierdurch bedingte höhere Leistungsaufnahme des Verstärkers ist aber auf die Zeitspanne beschränkt, in der das Eingangssignal u1 anliegt.

Da die den eingangsseitigen Pegel $U_{G1}$ auf den ausgangsseitigen Pegel $U_{A1}$ umsetzende Schaltung PU von den Verstärkereingängen 5, 6 her angesteuert wird, sind keine Regelkreise wie bei dem eingangs erwähnten, bekannten Differenzverstärker vorhanden, so daß das bei A auftretende Ausgangssignal, das an den Verbindungspunkten der Transistoren L1 und T1 und der Transistoren L2 und T2 abgegriffen und über die Stromspiegel L2, T4 sowie L1, T6 und T7, T5 an den Ausgang A übertragen wird, weitgehend verzerrungsfrei ist. Die Signalübertragung an den Ausgang geht dabei im einzelnen so vor sich, daß sich bei jeder durch die Aussteuerung von T2 und T1 mit dem Eingangssignal u1 bewirkten Größendifferenz der durch L2 und L1 fließenden Ströme eine entsprechende Größendifferenz der Ströme durch T4 und T5 ergibt, die zu einem an A abgreifbaren Ausgangsstrom führt. Beim Differenzverstärker nach der Erfindung spricht das Ausgangssignal sehr schnell auf die Schwankungen des Eingangssignals an, so daß auch Eingangssignale mit steil ansteigenden und abfallenden Flanken, z.B. Rechteckspannungen, weitgehend verzerrungsfrei und mit großer Stromerhöhung an den Ausgang A übertragen werden.

In Fig. 1 ist ein bevorzugtes Ausführungsbeispiel der pegelumsetzenden Schaltung PU innerhalb des linken strichpunktierten Blocks dargestellt. Die als Differenzverstärkerstufe aufgebaute Schaltung enthält im einzelnen zwei zwischen einem Schaltungsknoten 8 und dem mit $V_{DD}$ beschalteten Anschluß 3 angeordnete parallele Stromzweige, von denen der erste einen p-Kanal-Feldeffekttransistor T12 in Serie zu einem n-Kanal-Feldeffekttransistor T11 und der zweite einen p-Kanal-Feldeffekttransistor T14 in Serie zu einem n-Kanal-Feldeffekttransistor T13 aufweist. Der Schaltungsknoten 8 ist über einen Schaltungszweig, der die Source-Drain-Strecke eines n-Kanal-Feldeffekttransistors T15 enthält, mit dem Anschluß 4 verbunden, der mit dem Bezugspotential $V_{SS}$ beschaltet ist. Der Eingang 9 entspricht dem Gateanschluß von T13, der Eingang 10 dem Gateanschluß von T11. Der Ausgang 11 ist mit dem Verbindungspunkt der Transistoren T14 und T13 verbunden, der Ausgang 12 mit dem Verbindungspunkt der Transistoren T12 und T11. Zur Einstellung der Gatespannung von T15 dient ein zwischen den Anschlüssen 3 und 4 liegender Schaltungszweig, der die Serienschaltung eines p-Kanal-Deldeffekttransistors T22 und eines n-Kanal-Feldeffekttransistors T23 enthält. Das Gate von T22 ist mit dem Anschluß 4 verbunden, so daß ein bestimmter Strom durch diese Serienschaltung fließt, der durch $V_{DD}$ und das am Gate von T22 liegende Bezugspotential $V_{SS}$ gegeben ist. Das Gate von T23 ist mit dessen Drainanschluß verbunden. Die an diesem abfallende Spannung wird über eine Leitung 17 dem Gate von T15 zugeführt. Die Transistoren T12 und T14, deren strukturellen Auslegungen gleich sind, werden ebenso wie der Transistor T 15 in der Sättigung betrieben. Dies hat zwar zur Folge, daß der an den Ausgängen 11 und 12 auftretende Ausgangspegel, der ja $U_{A1}$ entsprechen sollte, in seiner Große unbestimmt ist, doch kann dieser Nachteil durch die Funktion des Gleichtakt-Regelkreises beseitigt werden, wenn man diesem eine Spannung $U_{ref}$ als Regelgröße zuführt, die dem gewünschten Ausgangspegel $U_{A1}$ entspricht.

Nachfolgend wird die in Fig. 1 dargestellte, bevorzugte Ausführungsform des Gleichtakt-Regelkreises näher beschrieben: Er besteht danach aus zwei kreuzgekoppelten Differenzverstärkerstufen. Die erste der beiden enthält zwei einander parallel geschaltete Schaltungszweige, von denen der erste die Serienschaltung eines als Lastelement geschalteten p-Kanal-Feldeffekttransistors L3 und eines n-Kanal-Feldeffekttransistors T16 aufweist, während der zweite Schaltungszweig die Serienschaltung eines als Lastelement geschalteten p-Kanal-Feldeffekttransistors L4 und eines n-Kanal-Feldeffekttransistors T17 aufweist. Diese Schaltungszweige sind über einen Schaltungsknoten 13 mit einem Stromquellentransistor T18 verbunden. Dabei ist die aus der Parallelschaltung der Schaltungszweige L3, T16 und L4, T17 und dem Stromquellentransistor T18 gebildete Serienschaltung zwischen die Anschlüsse 3 und 4 geschaltet. Der Stromquellentransistor T18 erhält seine Gatespannung von Drainanschluß des Transistors T23. Die zweite der kreuzgekoppelten Differenzverstärkerstufen enthält ebenfalls zwei einander parallel geschaltete Schaltungszweige, von denen der erste die Serienschaltung eines n-Kanal-Feldeffekttransistors T19 und des als Lastelement geschalteten Transistors L4 des zweiten Schaltungszweiges der ersten kreuzgekoppelten Diffe renzverstärkerstufe enthält, während der zweite die Serienschaltung eines n-Kanal-Feldeffekttransistors T20 und des als Lastelement geschalteten Transistors L3 des ersten Schaltungszweiges der ersten kreuzgekoppelten Differenzverstärkerstufe aufweist. Diese Schaltungszweige sind über einen Schaltungsknoten 14 mit einem Stromquellentransistor T21 verbunden. Dabei ist der aus der Parallelschaltung der Schaltungszweige L4, T19 und L3, T20 und dem Stromquellentransistor T21 gebildete Serienschaltung zwischen die Anschlüsse 3 und 4 geschaltet. Der Gateanschluß von T21 ist ebenfalls mit dem Drainanschluß von T23 beschaltet. Die Ausgänge 11 und 12 der pegelumsetzenden Schaltung PU sind mit den Gateanschlüssen von T20 und T16 verbunden, während die Gateanschlüsse von T17 und T19 mit einem Anschluß 16 beschaltet sind, dem die Referenzspannung $U_{ref}$ zugeführt wird. Der Gateanschluß von L4, der mit dem Drainanschluß von L4 verbunden ist, stellt den Ausgang 15 des Regelkreises dar. Er ist mit den Gateanschlüssen von T12 und T14 verbunden, die somit als Lastelemente aufzufassen sind, welche über den Ausgang 15 des Gleichtakt-Regelkreises 7 parallel angesteuert werden. Ohne das Auftreten eines zu verstärkenden Eingangssignals an 5 und 6 bzw. an 9 und 10 werden die Lastelemente T12 und T14 so angesteuert, daß an den Ausgängen 11 und 12 der pegelumsetzenden Schaltung PU jeweils ein Ausgangspegel $U_{A1}$ abgreifbar ist, der dem Wert der bei 16 zugeführten Referenzspannung $U_{ref}$ entspricht. Beim Anlegen eines Eingangssignals erhält man an den Ausgängen 11 und 12 die Spannungen u11 und u12, die invers zueinander verlaufen, deren Spannungswerte aber zu jedem Zeitpunkt einen arithmetischen Mittelwert aufweisen, der $U_{A1}$ entspricht. Jede Abweichung dieses Mittelwerts von $U_{A1}$ wird durch die Funktion des Regelkreises sofort beseitigt.

Fig. 3 zeigt das Beispiel einer Teilschaltung zur Ableitung von $U_{ref}$ aus der Versorgungsspannung $V_{DD}$. Sie besteht aus der Serienschaltung eines p-Kanal-Feldeffekttransistors T24 und eines n-Kanal-Feldeffekttransistors T25, die zwischen die Anschlüsse 3 und 4 geschaltet ist. Dabei ist der Gateanschluß von T25 mit dem Anschluß 3 verbunden, während der Gateanschluß von T24 mit seinem Drainanschluß beschaltet ist. Dieser Drainanschluß stellt den Ausgang 18 der Teilschaltung dar, an dem die Referenzspannung $U_{ref}$ abfällt, sofern die strukturelle Auslegung des Transistors T24 so erfolgt, daß der Quotient aus seiner Kanalweite und seiner Kanallänge dem Doppelten des entsprechenden Quotienten eines der beiden untereinander gleichartig ausgebildeten Transistoren T8 oder T9 entspricht.

Es liegt im Rahmen der Erfindung, die Kanaltypen der verwendeten Feldeffekttransistoren jeweils gegeneinander auszutauschen und gleichzeitig die Polaritäten der zugeführten Spannungen durch die entgegengesetzten zu ersetzen. Dabei sind dann auch die Spannungswerte von $U_{A1}$ und $U_{G1}$ miteinander zu vertauschen, was in Fig. 2 bedeutet, daß die Spannungsverläufe u5 und u6 an die Stelle der Spannungsverläufe u11 und u12 treten und umgekehrt. In diesem Fall setzt PU einen höheren Eingangspegel $U_{G1}$, d.h. den Gleichstromanteil des Eingangssignals u1, auf einen niedrigen Ausgangspegel $U_{A1}$ um. $U_{A1}$ liegt dann geringfügig über dem Wert der Einsatzspannung $U_t$ der Transistoren T8 und T9, die hierbei dem n-Kanaltyp angehören.

## Ansprüche

1. Differenzverstärker mit zwei parallelen Schaltungszweigen, die jeweils ein Lastelement (L1, L2) und einen Feldeffekttransistor (T1, T2) enthalten, und mit einem als Stromquelle dienenden Feldeffekttransistor (T3), der über einen ersten Schaltungsknoten (2) mit beiden parallelen Schaltungszweigen (L1, T1; L2, T2) verbunden ist und dessen Gateanschluß (G) mit einer Vorspannung beschaltet ist, die in diesen Schaltungszweigen fließende Ruheströme bestimmt, **dadurch gekennzeichnet,** daß eine Schaltungsstufe zur Einstellung der Ruheströme vorgesehen ist, die aus zwei parallel geschalteten p-Kanal-Feldeffekttransistoren (T8, T9) besteht, welche in Serie zu einem ausgangsseitigen Widerstand (T10) angeordnet sind, daß der ausgangsseitige Widerstand mit dem Gateanschluß (G) des als Stromquelle dienenden Feldeffekttransistors (T3) verbunden ist, daß eine pegelumsetzende Schaltung (PU) vorgesehen ist, die eingangsseitig mit den Gateanschlüssen (5, 6) der Feldeffekttransistoren (T1, T2) in den parallelen Schaltungszweigen verbunden ist, die ferner den Gleichstromanteil des Eingangssignals auf einen höheren Ausgangspegel umsetzt, der den Wert der Einsatzspannung der beiden einander parallel geschalteten p-Kanal-Feldeffekttransistoren (T8, T9) geringfügig unterschreitet, und die ausgangsseitig mit den Gateanschlüssen der letztgenannten p-Kanal-Feldeffekttransistoren (T8, T9) beschaltet ist, und daß die pegelumsetzende Schaltung (PU) mit einem Gleichtakt-Regelkreis (7) ausgestattet ist, dem eine dem Ausgangspegel entsprechende Referenzspannung als Regelgröße zugeführt wird.

2. Differenzverstärker mit zwei parallelen Schaltungszweigen, die jeweils ein Lastelement (L1, L2) und einen Feldeffekttransistor (T1, T2) enthalten, und mit einem als Stromquelle dienenden Feldeffekttransistor (T3), der über einen ersten Schaltungsknoten (2) mit beiden parallelen Schaltungszweigen (L1, T1; L2, T2) verbunden ist und dessen Gateanschluß (G) mit einer Vorspannung beschaltet ist, die in diesen Schaltungszweigen fließenden Ruheströme bestimmt, **dadurch gekennzeichnet,** daß eine Schaltungsstufe zur Einstellung der Ruheströme vorgesehen ist, die aus zwei einander parallel geschalteten n-Kanal-Feldeffekttransistoren besteht, welche in Serie zu einem ausgangsseitiger Widerstand angeordnet sind, daß der ausgangsseitige Widerstand mit dem Gateanschluß (G) des als Stromquelle dienenden Feldeffekttransistors (T3) verbunden ist, daß eine pegelumsetzende Schaltung (PU) vorgesehen ist, die eingangsseitig mit den Gateanschlüssen (5, 6) der Feldeffekttransistoren (T1, T2) in den parallelen Schaltungszweigen verbunden ist, die ferner den Gleichstromanteil des Eingangssignals auf einen niedrigeren Ausgangspegel umsetzt, der den Wert der Einsatzspannung der beiden einander parallel geschalteten n-Kanal-Feldeffekttransistoren geringfügig übersteigt, und die ausgangsseitig mit den Gateanschlüssen der letztgenannten n-Kanal-Feldeffekttransistoren beschaltet ist, und daß die pegelumsetzende Schaltung (PU) mit einem Gleichtakt-Regelkreis (7) ausgestattet ist, dem eine dem Ausgangspegel entsprechende Referenzspannung als Regelgröße zugeführt wird.

3. Differenzverstärker nach Anspruch 1 oder 2, **dadurch gekennzeichnet,** daß der ausgangsseitige Widerstand der Schaltungsstufe zur Einstellung der Ruheströme aus einem Feldeffekttransistor (T10) besteht, dessen Gateanschluß mit seinem Drainanschluß sowie mit dem Gateanschluß (G) des als Stromquelle dienenden Feldeffekttransistors (T3) verbunden ist.

4. Differenzverstärker nach einem der vorhergehenden Ansprüche, **dadurch gekennzeichnet,** daß die pegelumsetzende Schaltung (PU) aus einer Differenzverstärkerstufe besteht, die zwei einander parallel geschaltete Stromzweige enthält, von denen jeder eine Serienschaltung zweier Feldeffekttransistoren (T11, T12; T13, T14) unterschiedlicher Kanaltypen aufweist, daß ein erster Stromquellentransistor (T15) des einen Kanaltyps über einen zweiten Schaltungsknoten (8) mit diesen beiden Stromzweigen verbunden ist, daß die Gateanschlüsse der dem Kanaltyp des ersten Stromquellentransistors (T15) entsprechenden Feldeffekttransistoren (T11, T13) der Stromzweige die Schaltungseingänge (9, 10) der pegelumsetzenden Schaltung bilden, daß die Verbindungspunkte zwischen den letzteren Feld effekttransistoren (T11, T13) und den anderen beiden Feldeffekttransistoren (T12, T14) der Stromzweige die Schaltungsausgänge (11, 12) der pegelumsetzenden Schaltung (PU) darstellen und daß sowohl diese anderen beiden Feldeffekttransistoren (T12, T14) als auch der Stromquellentransistor (T15) im Sättigungsgebiet betrieben werden.

5. Differenzverstärker nach Anspruch 4, **dadurch gekennzeichnet,** daß der Gleichtakt-Regelkreis (7) aus zwei kreuzgekoppelten Differenzverstärkerstufen besteht, daß die erste derselben zwei einander parallel geschaltete Schaltungszweige aufweist, von denen der erste die Serienschaltung eines als Lastelement geschalteten Feldeffekttransistors (L3) eines ersten Kanaltyps und eines Feldeffekttransistors (T16) des zweiten Kanaltyps aufweist, und der zweite die Serienschaltung eines weiteren als Lastelement geschalteten Feldeffekttransistors (L4) des ersten Kanaltyps und eines weiteren Feldeffekttransistors (T17) des zweiten Kanaltyps enthält, daß diese beiden Schaltungszweige über einen dritten Schaltungsknoten (13) mit einem zweiten Stromquellentransistor (T18) verbunden sind, daß die zweite der kreuzgekoppelten Differenzverstärkerstufen ebenfalls zwei einander parallel geschaltete Schaltungszweige aufweist, wobei der erste derselben die Serienschaltung eines zusätzlichen Feldeffekttransistors (T19) des zweiten Kanaltyps und des als Lastelement geschalteten Feldeffekttransistors (L4) des zweiten Schaltungszweiges der ersten kreuzgekoppelten Differenzverstärkerstufe enthält, und der zweite Schaltungszweig der zweiten kreuzgekoppelten Differenzverstärkerstufe die Serienschaltung eines weiteren zusätzlichen Feldeffekttransistors (T20) des zweiten Kanaltyps und des als Lastelement geschalteten Feldeffekttransistors (L3) des ersten Schaltungszweiges der ersten kreuzgekoppelten Differenzverstärkerstufe enthält, daß die Schaltungszweige (T19, L4; T20, L3) der zweiten kreuzgekoppelten Verstärkerstufe über einen dritten Schaltungsknoten (14) mit einem dritten Stromquellentransistor (T21) verbunden sind, daß die Ausgänge (12, 11) der pegelumsetzenden Schaltung (PU) an die Gateanschlüsse der Feldeffekttransistoren (T16, T20) des zweiten Kanaltyps des ersten Schaltungszweigs der ersten und des zweiten Schaltungszweigs der zweiten kreuzgekoppelten Differenzverstärkerstufe geführt sind, daß der Gateanschluß des dem zweiten Schaltungszweig der ersten und dem ersten Schaltungszweig der zweiten kreuzgekoppelten Differenzverstärkerstufe angehörenden, als Lastelement geschalteten Feldeffekttransistors (L4), der den Ausgang (15) des Gleichtakt-Regelkreises (7) darstellt, sowohl mit dem Drainanschluß dieses Transistors (L4) als auch mit den Gateanschlussen der anderen beiden Feldeffekttransistoren (T12, T14) in den beiden Stromzweigen der Differenzverstärkerstufe der pegelumsetzenden Schaltung (PU) verbunden ist, und daß die Gateanschlusse der Feldeffekttransistoren (T17, T19) des zweiten Kanaltyps des zweiten Schaltungszweiges der ersten und des ersten Schaltungszweiges der zweiten kreuzgekoppelten Differenzverstärkerstufe mit einem Anschluß (16) verbunden sind, der mit einer Referenzspannung beschaltet ist.

FIG 1

FIG 2

FIG 3

EP 0 351 708 A2